# EUROPÄISCHE PATENTANMELDUNG

(11) **EP 1 830 619 A2**
(43) Veröffentlichungstag der Anmeldung: **05.09.2007**
(21) Anmeldenummer: 07450034.9
(22) Anmeldetag: 21.02.2007
(51) Int. Cl.: H05K 7/06

(54) **Fixierelement für elektrische Leiter, Leiterstruktur-Bauteil und Verfahren zu dessen Herstellung**

(30) Priorität: 03.03.2006 AT 3652006; 30.05.2006 AT 9312006
(71) Anmelder: Pollmann Austria OHG, 3822 Karlstein/Thaya (AT)
(72) Erfinder: Pollmann, Robert, 3822 Karlstein (AT); Weber, Harald, 3822 Karlstein (AT); Wimmer, Walter, 3823 Weikertschlag/Thaya (AT)
(74) Vertreter: Sonn & Partner Patentanwälte

(57) **Zusammenfassung**

Für einen Leiterstruktur-Bauteil (1) mit Kunststoff-Umspritzung (5) wird ein Fixierelement (4') für elektrische Leiter eingesetzt, das durch einen vorgefertigten Trägerkörper (4) mit Aufnahmen (3) für die Halterung von einzelnen Drähten (2) als elektrische Leiter gebildet ist.

## Beschreibung

Die Erfindung betrifft ein Fixierelement für elektrische Leiter, für die Herstellung eines Leiterstruktur-Bauteils durch Kunststoff-Umspritzung.

Weiters bezieht sich die Erfindung auf einen elektrischen Leiterstruktur-Bauteil mit einem solchen Fixierelement und elektrischen Leitern innerhalb einer Kunststoff-Umspritzung.

Ferner betrifft die Erfindung ein Verfahren zum Herstellen eines elektrischen Leiterstruktur-Bauteils, wobei elektrische Leiter mit Kunststoff umspritzt werden.

Aus der DE 10 2004 020 085 A1 und der EP 1 357 774 A1 ist es für die Fertigung von Bauteilen mit elektrischen Leiterstrukturen bekannt, als Grundelement metallische Stanzgitter zu verwenden. Diese Stanzgitter werden vorab in einer Spritzgussform teilweise mit Kunststoff umspritzt, so dass einzelne Bereiche des Stanzgitters durch die Kunststoff-Elemente miteinander verbunden und dadurch fixiert werden. Danach werden ursprünglich für den Zusammenhalt des Stanzgitters notwendige Stege, die aufgrund der Vorumspritzung der Leiter mittels des Kunststoffs, also durch die Kunststoff-Fixierelemente, überflüssig geworden sind, durchtrennt. Gegebenenfalls können am Stanzgitter elektronische Komponenten, z.B. durch Anlöten, angebracht werden. Anschließend wird das Stanzgitter als Ganzes zwecks Isolierung und zur Erzielung eines stabilen, gut montierbaren Bauteils in einem weiteren Spritzvorgang mit Kunststoff umspritzt, wobei der dann erhaltene Bauteil gegen äußere Einflüsse, wie Feuchtigkeit, gut isoliert ist. Hierdurch eignen sich diese Bauteile u.a. für Anwendungen in Kraftfahrzeugen, beispielsweise im Bereich von Türen, für Türschlösser, und Fensterheber, aber auch für Scheibenwischeranlagen oder dgl. Einrichtungen mit elektrischen Komponenten.

Aus der DE 1 190 544 A (= BE 658 431 A) und DE 1 590 728 A ist es andererseits bekannt, mehrere in einer Reihe angeordnete Kontakte, insbesondere Schiebeschalter, herzustellen, indem kurze Drähte nebeneinanderliegend in einem Isolierstreifen befestigt werden. Die Enden der Drähte stehen an beiden Seiten des Isolierstreifens vor und werden durch Prägen zu den Kontaktelementen geformt. Die Drähte können im Isolierstreifen eingedrückt, eingeklemmt oder eingeklebt, aber auch mit dem Isolierstreifen umspritzt oder umpresst werden.

Aus der US 4,965,933 A ist die Herstellung von umspritzten Leiterbahnen bekannt, wobei Leiterbahnen, welche zuvor durch Verbindungsstücke miteinander verbunden waren, in der Form voneinander getrennt werden müssen, bevor der Kunststoff eingespritzt wird. Dies ist ein zusätzlicher Arbeitsschritt, der den Aufwand erhöht, wobei überdies die Gefahr besteht, dass beim Einspritzen des Kunststoffs in die Form die getrennten Leiterbahnen-Teile ungewollt verrutschen.

In der DE 102 22 285 C1 ist die Herstellung einer Flachbandleitung durch Extrusion beschrieben, wobei die Leiterbahnen in einem ersten Schritt in einem Isolierungsteil fixiert werden, wonach in einem zweiten Schritt die Isolierung vervollständigt wird.

Aus der DE 102 47 567 A1 ist ein Gehäuse-artiger Träger für elektrische Komponenten bekannt, bei dessen Herstellung aus Blech ausgestanzte Leiterbahnen umspritzt werden, wobei Kontaktierungsstellen der Leiterbahnen aus dem Träger herausragen.

Aufgabe der Erfindung ist es nun, eine besonders einfache und kostengünstige Herstellung von Leiterstruktur-Bauteilen zu ermöglichen und hiefür auch vorteilhafte Fixierelemente zur Verfügung zu stellen, wobei überdies ein hohes Maß an Flexibilität, z.B. für kurzfristige Änderungen der Leiter-Positionen, gewährleistet sein soll.

Zur Lösung dieser Aufgabe sieht die Erfindung ein Fixierelement bzw. einen Bauteil sowie ein Verfahren gemäß den unabhängigen Ansprüchen vor. Vorteilhafte Ausführungsformen und Weiterbildungen sind in den Unteransprüchen definiert.

Bei der erfindungsgemäßen Technik wird als Fixierelement ein eigenes, vorgefertigtes Element in Form eines - vorzugsweise plattenförmigen - Trägerkörpers eingesetzt, und die Leiter werden anstatt durch ein Stanzgitter durch an diesem Trägerkörper gehaltene Drähte vorgesehen. Dazu weist der Trägerkörper entsprechende Aufnahmen für die Drähte auf, wobei die Drähte in den zugehörigen Aufnahmen in einem leichten Presssitz, in einem Schnapp- bzw. Rastsitz und/oder formschlüssig gehalten sein können. Die Fixierung der Drähte am Trägerkörper muss nur so weit ausreichend sein, dass beim Umspritzen des Trägerkörpers samt Drähten mit Kunststoff kein Lösen der Drähte aus ihren Aufnahmen erfolgt. Besonders vorteilhaft ist es hierbei, wenn die Aufnahmen zumindest bereichsweise rinnenförmig ausgebildet sind, wobei diese rinnenförmigen Aufnahmen beispielsweise durch Vertiefungen im Trägerkörper gebildet und/oder durch am Trägerkörper hochstehende Rinnenwände begrenzt sind. Die Aufnahmen können im Querschnitt gesehen hinterschnitten sein, etwa zur Bildung elastisch verformbarer Rastsitze, sie können aber auch, nach dem Einlegen oder Einziehen der Drähte, mit Hilfe eines Stempelwerkzeuges, gegebenenfalls unter Anwendung von Wärme, verprägt sein, so dass die Drähte in der jeweiligen Aufnahme formschlüssig gehalten werden. Zusätzlich oder anstatt dessen kann zur elastischen Fixierung der Drähte am Trägerkörper auch vorgesehen werden, zumindest einen elastischen verformbaren Halteclip oder Klemmteil als Schnapphalterung für den jeweils aufgenommenen Draht vorzusehen. Dieses Klemmelement bzw. dieser Halteclip ist insbesondere im Bereich eines bogenförmigen Verlaufs des Drahtes am Trägerkörper vorgesehen, da dort unter Umständen höhere Kräfte auf den jeweiligen Draht einwirken.

Der Trägerkörper ist bevorzugt ein Kunststoff-Spritzgussteil, der je nach der spezifischen Anwendung hinsichtlich Dimensionen und Form bestimmt wird; dabei können die insbesondere rinnenförmigen Aufnahmen ebenso wie die etwaigen Halteclips problemlos mitgespritzt werden, wobei auch zumindest bereichsweise die bereits angesprochenen Hinterschneidungen an den rinnenförmigen Aufnahmen gleichzeitig erzeugt werden, wenn eine Schnapphalterung oder Verrastung in den elastisch verformbaren Aufnahmen vorgesehen werden soll.

Am Trägerkörper können weiters an zumindest einem Rand Steckerkontakte, z.B. durch Festklemmen, fest angebracht sein, und die in den Aufnahmen gehaltenen Drähte werden mit diesen Steckerkontakten elektrisch verbunden, z.B. durch Löten, Schweißen, durch Anklemmen oder durch Schneidkontakte oder dgl. Verbindungstechniken. Beim fertigen Leiterstruktur-Bauteil stehen diese Steckerkontakte aus der Kunststoff-Umspritzung vor, wobei sie gewünschtenfalls, zum Schutz sowie zur Abdichtung, auch von einem Kunststoff-Gehäuseteil, der einteilig mit der Umspritzung ist, umgeben sein können.

Wenn an dem Leiterstruktur-Bauteil außen nachträglich eine elektrische Komponente, wie ein Schalter und/oder ein Elektromotor, befestigt werden soll, so ist es zweckmäßig, zwecks Anschluss dieser Komponenten an die Leiterstruktur die entsprechenden Drähte vom Trägerkörper abzubiegen, wobei die abgebogenen Drahtteile beim fertigen Leiterstruktur-Bauteil durch die Kunststoff-Umspritzung nach außen ragen, um so die elektrische Verbindung zur jeweiligen Komponente herstellen zu können.

Verfahrensmäßig ergibt sich für die Herstellung eines erfindungsgemäßen elektrischen Leiterstruktur-Bauteils insofern eine Vereinfachung, als vorweg bloß ein angepasster Trägerkörper für die Aufnahme der Drähte herzustellen ist, was problemlos durch Spritzen aus Kunststoff in den verschiedensten Formen geschehen kann, wonach als elektrische Leiter einfach Drähte in die Aufnahmen des Trägerkörpers eingelegt und darin fixiert werden, wobei abschließend der Trägerkörper samt den Drähten mit Kunststoff umspritzt wird. Das Einlegen der Drähte erfolgt bevorzugt mit Hilfe eines an sich üblichen Drahtbestückungsroboters, wobei komplexe elektrische Verbindungen möglich sind, und wobei auch je nach Fall passende Trägerkörper und damit Änderungen der Leiterbahnen einfach möglich sind. Die relativ aufwendige Herstellung der metallischen Stanzgitter, wie sie beim Stand der Technik notwendig war, entfällt bei der vorliegenden Technik, so dass sich eine außerordentlich kostengünstige Herstellung ergibt.

Die Erfindung wird nachfolgend anhand von besonders bevorzugten Ausführungsbeispielen, auf die sie jedoch nicht beschränkt sein soll, und unter Bezugnahme auf die Zeichnung noch weiter erläutert. In der Zeichnung zeigen:
Fig. 1 schematisch in einer schaubildlichen Darstellung einen Leiterstruktur-Bauteil mit Trägerkörper, daran fixierten Drähten und einer strichliert gezeichneten Kunststoff-Umspritzung;
Fig. 2 einen Teil des beim Bauteil von Fig. 1 vorgesehenen Trägerkörpers samt Drähten;
Fig. 3 einen Ausschnitt aus dem Trägerkörper gemäß Fig. 2, gemäß dem Detail III, in einer schaubildlichen Ansicht, zwecks Veranschaulichung von Halteclips;
Fig. 4 einen Teil-Querschnitt gemäß der Linie IV-IV in Fig. 3 zur Veranschaulichung der Form und Wirkung der Halteclips;
Fig. 5 eine schaubildliche Darstellung eines modifizierten Leiterstruktur-Bauteils gemäß der Erfindung mit einem daran befestigten Elektromotor, mit einem ebenfalls daran befestigten Schalter sowie mit einer Anordnung von Steckerkontakten mit einer Gehäuse-förmigen Umhüllung;
Fig. 6 eine Draufsicht auf die Anordnung gemäß Fig. 5;

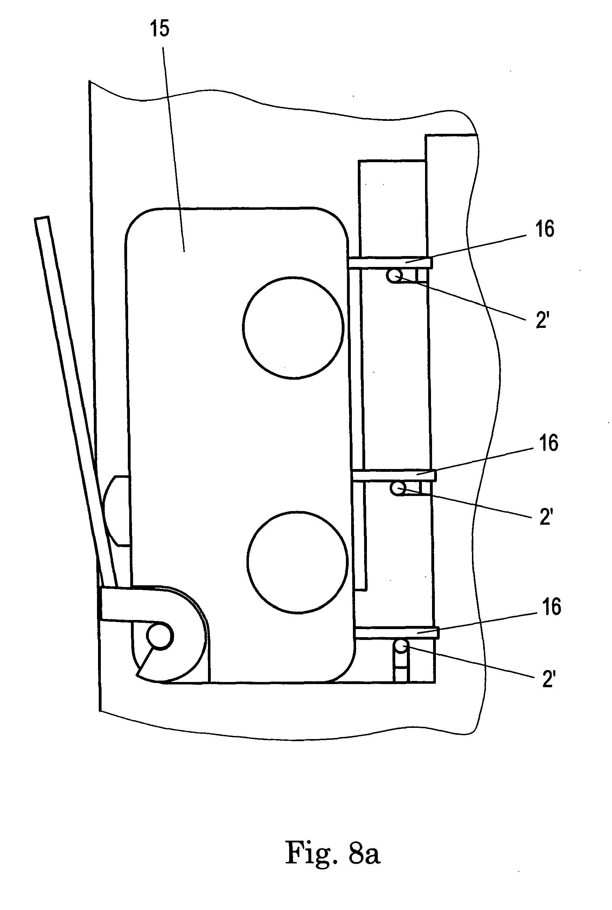

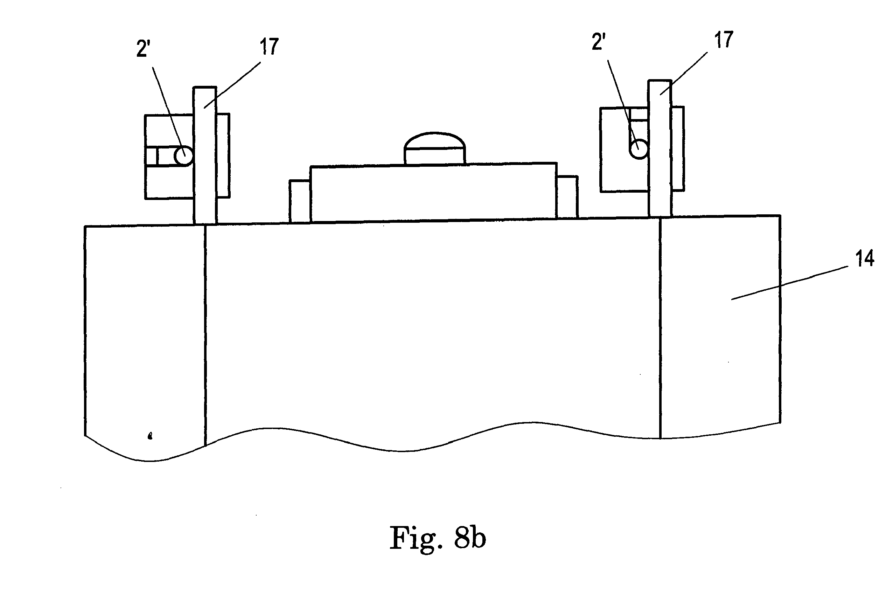

Fig. 7 einen Schnitt durch diese Anordnung, gemäß der Linie VII-VII in Fig. 6; die Fig. 8a und 8b die Details VIIIa und VIIIb aus Fig. 6 in demgegenüber vergrößertem Maßstab;
Fig. 9 schaubildlich den Trägerkörper für den Bauteil gemäß Fig. 5 samt daran gehaltenen Drähten als elektrische Leiter sowie Steckerkontakten, noch vor der Fertig-Umspritzung;
Fig. 10 die Unterseite des Trägerkörpers gemäß Fig. 9 in schaubildlicher Ansicht;
Fig. 11 in einer entsprechenden Unteransicht, jedoch in vergrößertem Maßstab, einen Teil dieses Trägerkörpers gemäß Fig. 10, mit den Steckerkontakten, gemäß dem Detail XI in Fig. 10;
Fig. 12 eine schaubildliche Darstellung eines zur Herstellung eines Leiterstruktur-Bauteils gemäß Fig. 17 vorgesehenen Fixierelements, das auf einer starren Unterlage, dass bei einem Prägeschritt ein Gegenwerkzeug bildet, fest angeordnet ist;
Fig. 13 in einem schematischen Schnitt das Fixierelement auf der Unterlage sowie einem darüber angeordneten, an die Oberseite des Fixierelements herangeführten Prägestempel;
Fig. 14 in einem Detailschnitt entsprechend dem Detail XIV in Fig. 13 den Bereich einer Aufnahme des Trägerkörpers des Fixierelements, wobei ersichtlich ist, dass diese Aufnahme an der Oberseite durch den Prägestempel verschlossen ist, und wobei im Vergleich zu Fig. 13 auch bereits ein Draht in die Aufnahme eingeführt worden ist;
Fig. 15 die Anordnung aus Prägestempel, Trägerkörper und Unterlage gemäß Fig. 14 nach einem Prägeschritt, wobei die am Trägerkörper fixierten Drähte durch Verprägen formschlüssig festgehalten werden;
Fig. 16 in einem Detailschnitt im größeren Maßstab, gemäß dem Detail XVI in Fig. 15, den Trägerkörper 4 mit der durch das Verprägen hergestellten formschlüssigen Fixierung eines Drahtes; und
Fig. 17 eine der Darstellung in Fig. 12 vergleichbare schaubildliche Darstellung des fertigen Leiterstruktur-Bauteils, jedoch noch vor dem Umspritzen mit Kunststoff.

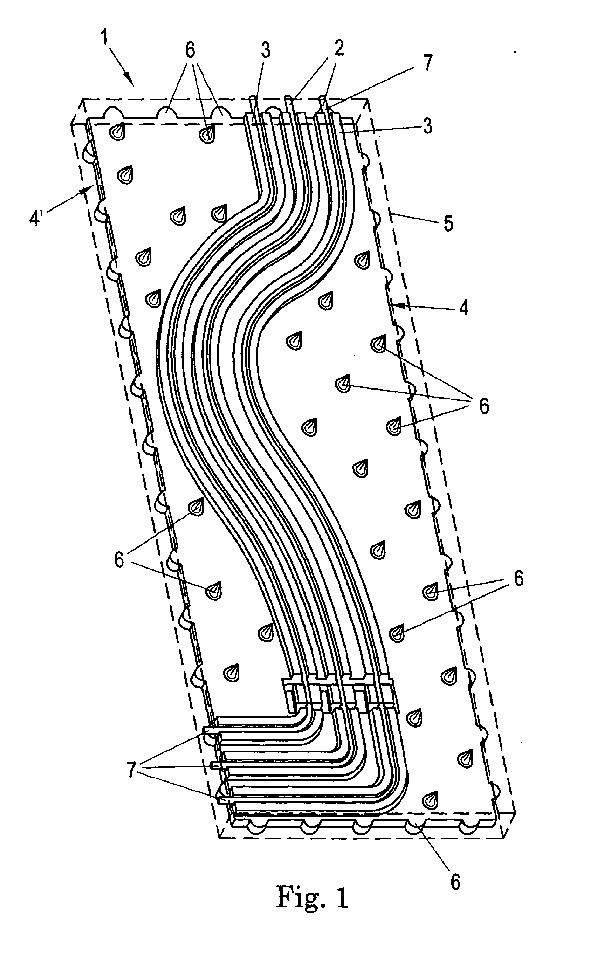

In Fig. 1 ist schematisch in schaubildlicher Darstellung ein einfacher Bauteil 1 mit einer elektrischen Leiterstruktur gezeigt, welche mehrere Drähte 2 als elektrische Leiter enthält, die je nach Bedarf und Notwendigkeit, nach Einsatzzweck des Bauteils 1, einen geraden, winkelförmigen, gekrümmten etc. Verlauf innerhalb des Bauteils 1 aufweisen.

Im Einzelnen sind die Drähte in Aufnahmen 3 eines bevorzugt plattenförmigen Trägerkörpers 4 fixiert, die als Leiter-Fixierelement 4' vorgesehen ist. Dieser beispielhaft plattenförmige Trägerkörper 4 wird nachstehend einfach auch als Trägerplatte 4 bezeichnet. An sich kann aber der Trägerkörper 4 bei bestimmten Anwendungen auch z.B. quaderförmig sein, die Plattenform wird jedoch in der Regel wegen der Möglichkeit, viele Drähte 2, auch mit einem kurvenförmigen Verlauf, platzsparend unterzubringen, bevorzugt werden. Die Trägerplatte 4 ist zusammen mit den Drähten 2 in einer Kunststoff-Umspritzung 5 eingebettet, wobei diese Kunststoff-Umspritzung zwecks besserer Veranschaulichung der übrigen Teile in Fig. 1 nur mit strichlierten Linien angedeutet ist.

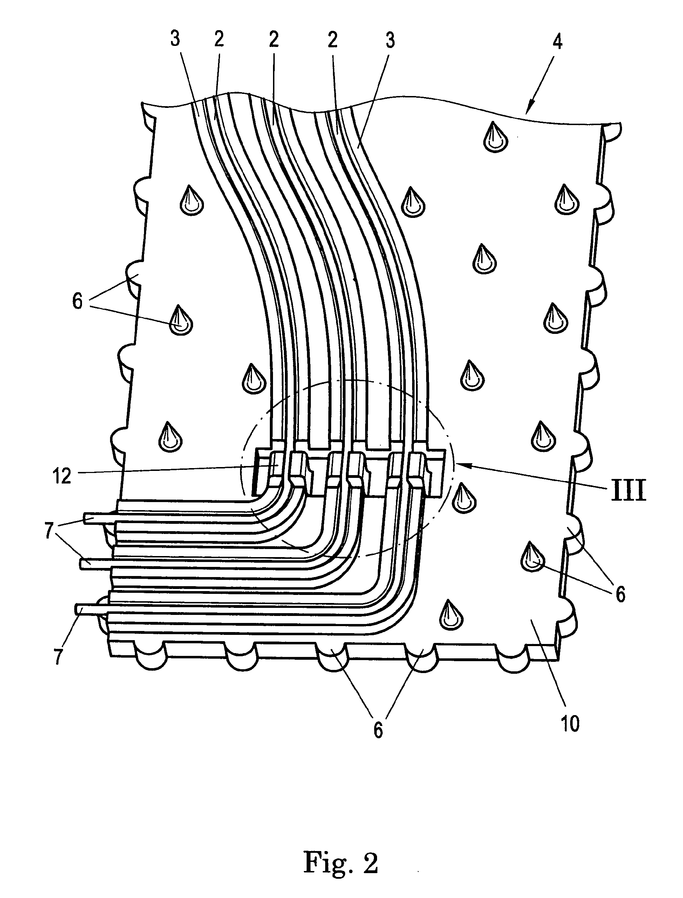

Zur Herstellung dieser Kunststoff-Umspritzung 5 wird die Trägerplatte 4 samt den in den Aufnahmen 3 gehaltenen Drähten 2 in ein Spritzgusswerkzeug (nicht dargestellt) eingelegt und mit Kunststoff umspritzt, wobei beispielsweise noppenförmige Distanzelemente 6 die Trägerplatte 4 im Spritzgusswerkzeug in Position halten, indem sie an entsprechenden Flächen des Werkzeugs anliegen. Aus dem so gebildeten Bauteil ragen Enden 7 der Drähte 2 für eine Kontaktierung aus dem Bauteil 1 heraus, vgl. im Übrigen außer Fig. 1 auch Fig. 2, in der die Trägerplatte 4 samt in den Aufnahmen 3 fixierten Drähten 2 noch ohne Kunststoff-Umspritzung bereichsweise, im Vergleich zu Fig. 1 in größerem Maßstab, veranschaulicht ist.

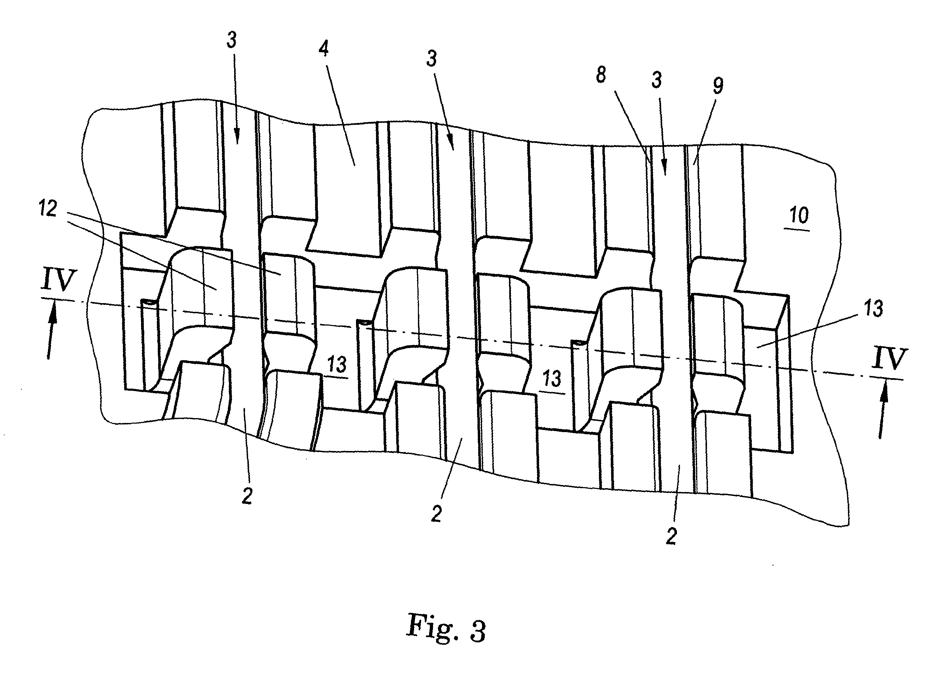

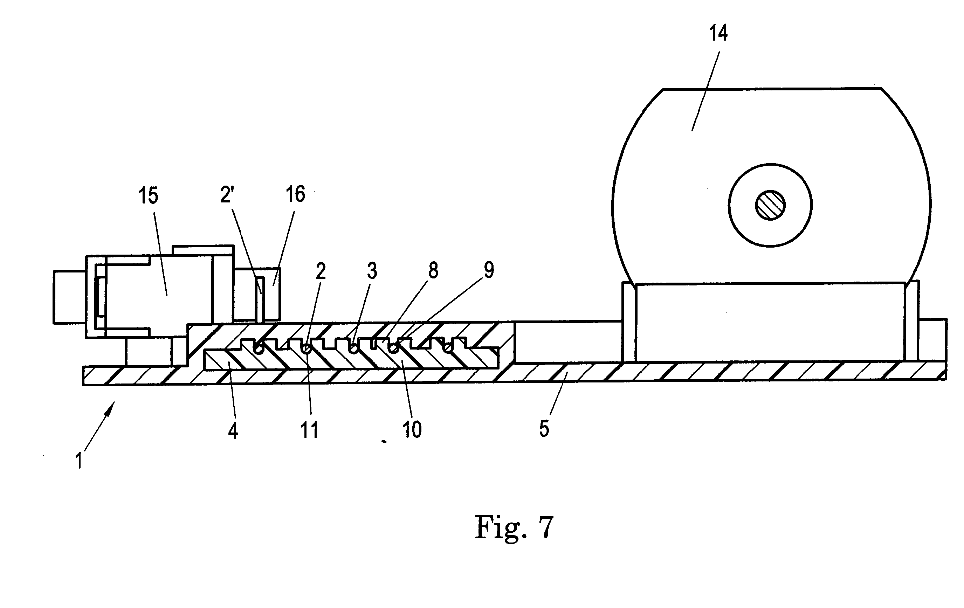

Die Aufnahmen 3 sind, wie außer aus Fig. 1 und 2 insbesondere auch aus Fig. 3 hervorgeht, rinnenförmig ausgebildet, wobei die rinnenförmigen Aufnahmen 3 durch Wände 8, 9 begrenzt sind, vgl. auch die Querschnittsdarstellung von Fig. 7. Die rinnenförmigen Aufnahmen 3 sind einerseits durch diese Wände 8, 9 begrenzt, die sich vom Haupt-Körper 10 der Trägerplatte 4 nach oben erstrecken, zum Teil sind sie jedoch auch durch Vertiefungen 11 im Haupt-Körper 10 der Trägerplatte gebildet (s. Fig. 7), d.h. der Boden der die Aufnahmen 3 bildenden Nuten liegt verglichen mit der Oberseite des Haupt-Körpers 10 der Trägerplatte 4 etwas tiefer, und andererseits ragen die Wände 8, 9 vom Haupt-Körper 10 der Trägerplatte 4 in die Höhe; dadurch ist eine begrenzte laterale elastische Deformation der Wände 8, 9 möglich, so dass die Wände 8, 9 mit leichten Hinterschneidungen an ihrer Oberseite ausgebildet oder mit einem engen gegenseitigen Abstand vorgesehen sein können, so dass die Drähte 2 in einem Schnappsitz bzw. in einem leichten Presssitz in den rinnenförmigen Aufnahmen 3 festgehalten werden.

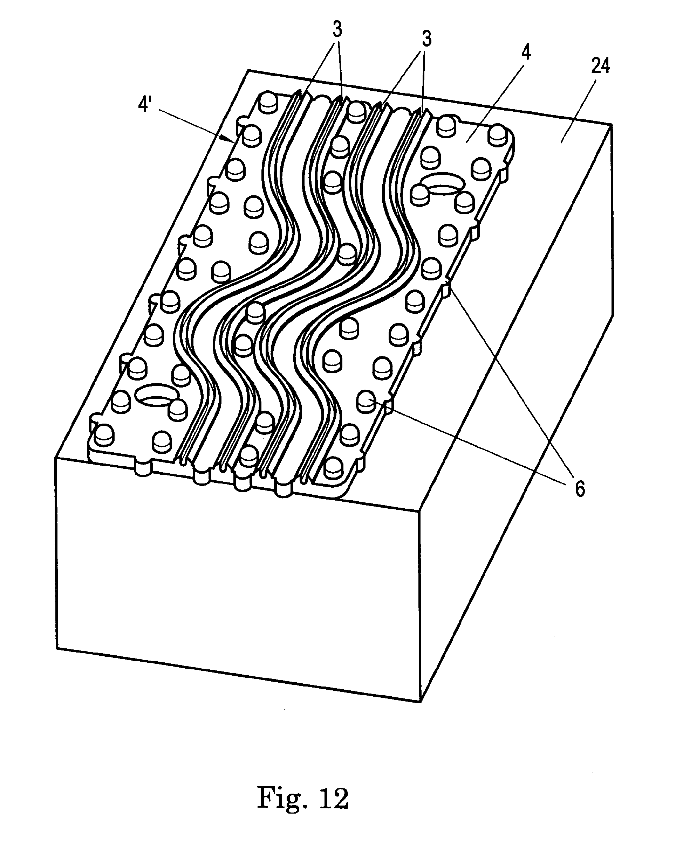

Eine andere Möglichkeit zur Fixierung der Drähte 2 in den Aufnahmen 3 besteht darin, die Oberseite der Trägerplatte 4, d.h. der Wände 8, 9, mit einem geeigneten, gegebenenfalls erhitzten Presswerkzeug bzw. Prägestempel zu verprägen, so dass die Wände 8, 9 plastisch verformt werden, und so die Drähte 2 durch aufgrund der Verformung erhaltene übergreifende Teile in den Nuten der Aufnahmen 3 formschlüssig festgehalten werden. Die Drähte 2 können dabei entweder in die an der Oberseite noch offenen Aufnahmen 3 von oben her eingelegt werden, wonach die Verprägung erfolgt, oder erst nach Schließen der Aufnahmen 3 an der Oberseite mit Hilfe eines Prägestempels in die dann Tunnel-artigen Aufnahmen eingeschoben werden. In beiden Fällen wird danach durch eine Relativbewegung von Prägestempel und Unterlage (mit Trägerplatte 4) in Richtung aufeinander zu die (endgültige) Verprägung der Trägerplatte 4, zwecks Verformung der Ränder der Aufnahmen 3 für die Drähte 2, bewerkstelligt. Eine entsprechende Technik wird nachfolgend noch näher anhand der Fig. 12 bis 17 erläutert werden.

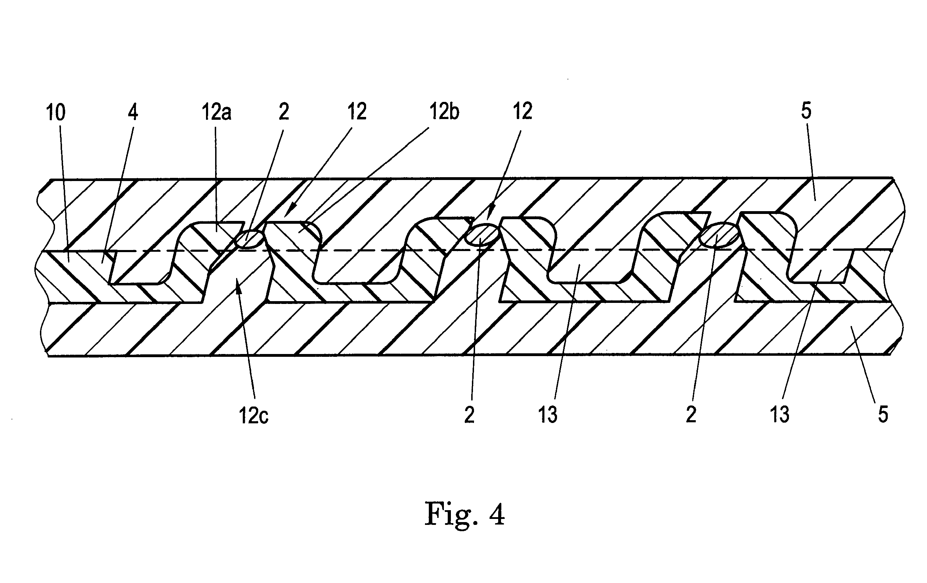

Zusätzlich zu den rinnenförmigen Aufnahmen 3, gegebenenfalls aber auch anstatt dieser rinnenförmigen Aufnahmen 3, können zur Fixierung der Drähte 2 auch Aufnahmen in Form von Klemmelementen oder Halteclips 12 vorgesehen werden. Hierbei handelt es sich, wie insbesondere aus Fig. 3 und 4 ersichtlich ist, im Einzelnen um Paare von elastisch auslenkbaren Klauen 12a, 12b, die paarweise den jeweiligen Draht 2 in einem Schnapp- oder Rastsitz festhalten; aus spritztechnischen Gründen ist die Trägerplatte 4 im Bereich zwischen jeweils zwei Klauen 12a, 12b eines solchen Halteclips 12 durchbrochen, wie in Fig. 4 bei 12c veranschaulicht ist. In Draufsicht unmittelbar anschließend an die jeweiligen Halteclips 12 ist jedoch der Körper 10 der Trägerplatte 4 wieder vorhanden, so dass dort der jeweilige Draht 2 auf dem Haupt-Körper 10 der Trägerplatte 4, genauer auf dem Nutboden der Aufnahme 3, aufliegt und so durch die aus der Darstellung in Fig. 3 und 4 ersichtlichen, schräg abwärts geneigten Schrägflächen der Klauen 12a, 12b der Halteclips 12 fest gegen den Haupt-Körper 10 der Trägerplatte 4 gehalten werden kann. Außerhalb der einzelnen Halteclips 12 ist der Haupt-Körper 10 der Trägerplatte 4 vertieft, s. die Vertiefungen 13 in Fig. 3 und 4, um so das beim Eindrücken der Drähte 2 notwendige elastische Auslenken der Klemmteile, d.h. der Klauen 12a, 12b der Halteclips 12, leichter zu ermöglichen.

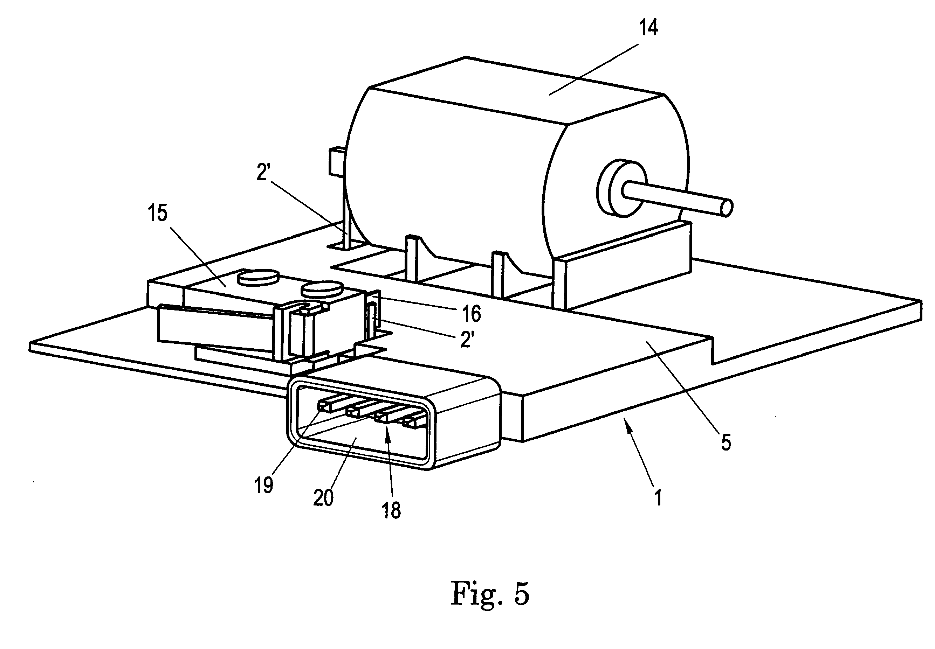

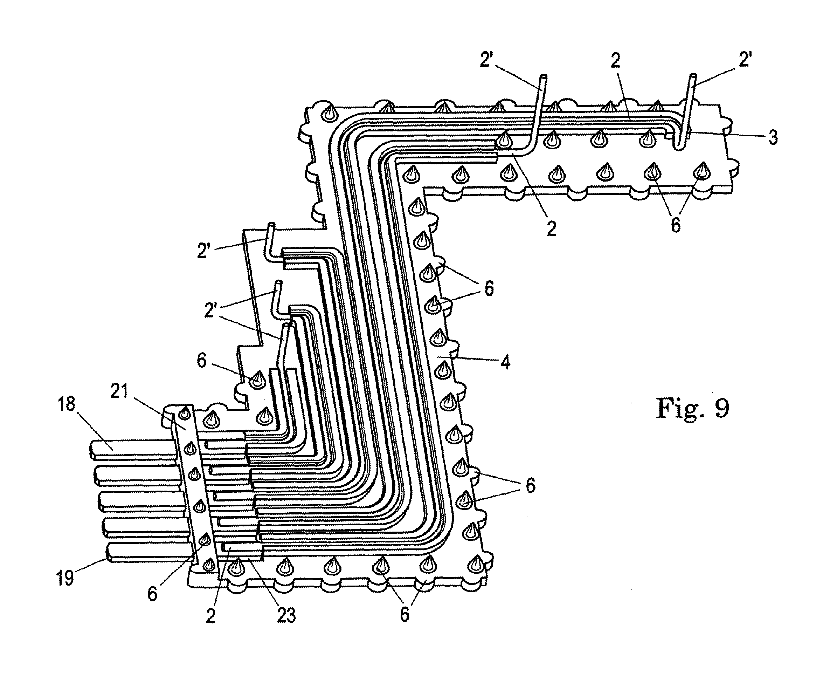

In Fig. 5 bis 7 ist ein vergleichbarer Leiterstruktur-Bauteil 1 mit einem plattenförmigen Trägerkörper, d.h. einer Trägerplatte 4 (s. Fig. 7) und einer Kunststoff-Umspritzung 5 gezeigt; überdies sind auf diesem Bauteil 1, auf der Kunststoff-Umspritzung 5, äußere Komponenten montiert, wie z.B. ein kleiner elektrischer Motor 14 und ein Schalter 15. Der Schalter 15 ist beispielsweise als Taster ausgebildet, und seine Anschlüsse 16 sind mit aus der Ebene der Trägerplatte 4 hochgebogenen Endstücken 2' der Drähte 2 elektrisch, z.B. durch Löten oder Schweißen, verbunden. Die hochstehenden Endstücke 2' der Drähte 2 sind insbesondere aus Fig. 9 ersichtlich, in der die Trägerplatte 4 noch ohne Kunststoff-Umspritzung 5, jedoch mit in den rinnenförmigen Aufnahmen 3 eingelegten Drähten 2, dargestellt ist. In ähnlicher Weise sind zwei Endstücke 2' der Drähte 2 im gemäß der Darstellung in Fig. 9 rechts oben gelegenen Bereich mit Anschlüssen 17 des Motors 14 elektrisch verbunden, beispielsweise ebenfalls durch Löten oder Schweißen.

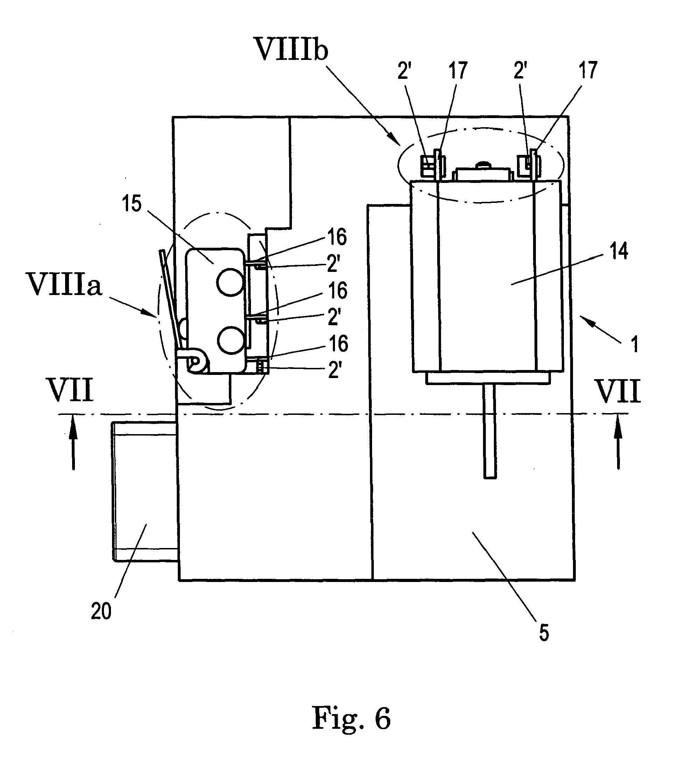

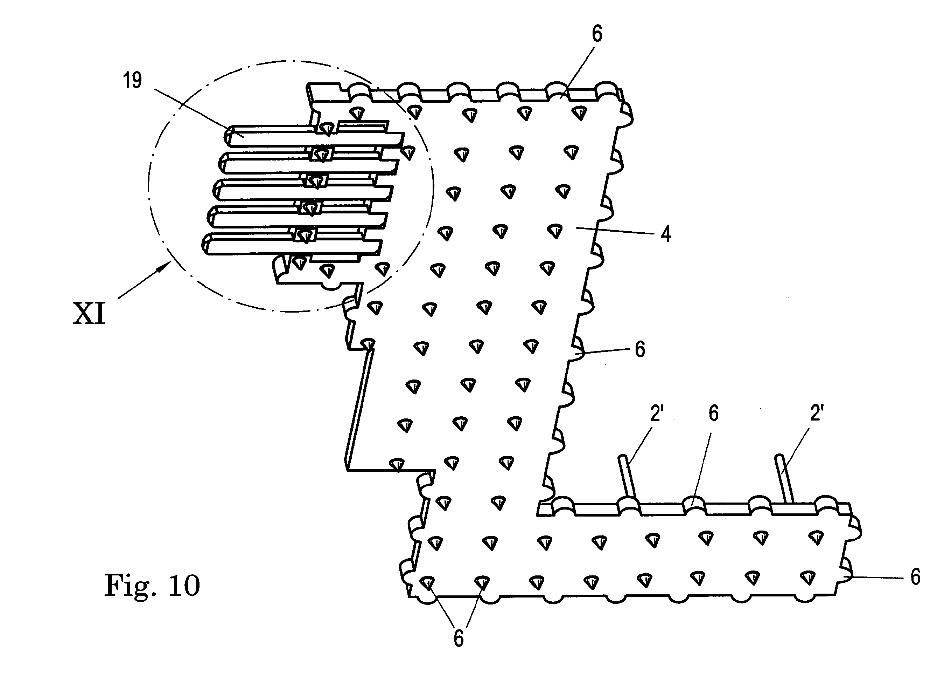

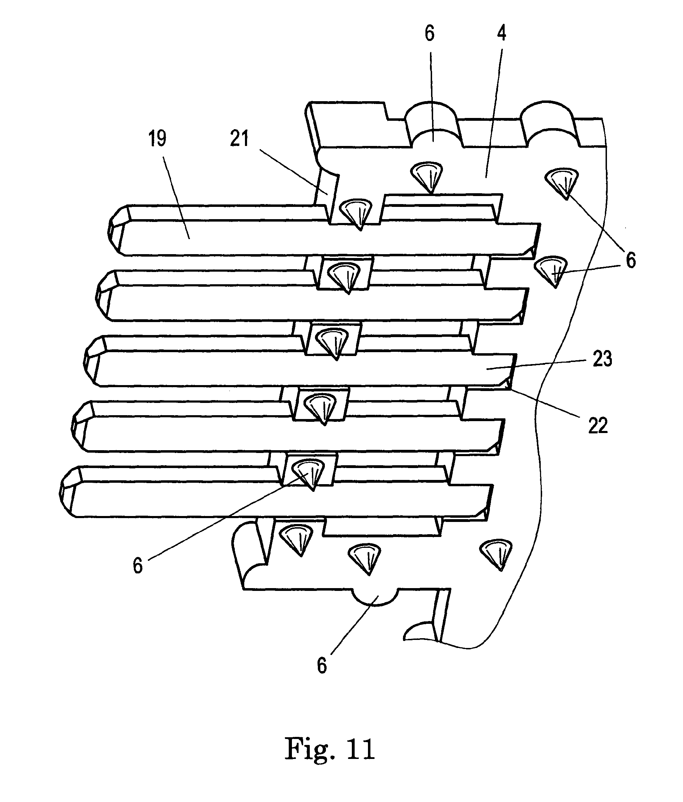

Aus den Fig. 5 und 6 sowie insbesondere auch aus den Fig. 9 bis 11 ist ersichtlich, dass zum elektrischen Anschließen des Bauteils 1 Steckerkontakte 18 mit einzelnen Kontaktstiften 19 vorgesehen sind, die vom Bauteil 1 randseitig seitlich abstehen und beim fertigen Bauteil 1 von einer Gehäuse-förmigen Umhüllung 20, die die Steckerkontakte 18 schützend und abdichtend umschließt, umgeben sind. Diese Umhüllung 20 ist in einem Stück mit der Kunststoff-Umspritzung 5 hergestellt, d.h. beim Umspritzen der Trägerplatte 4 samt Drähten 2 hergestellt.

Die einzelnen Kontaktstifte 19 werden, wie aus Fig. 9 bis 11 ersichtlich ist, an der Trägerplatte 4 unterseitig durch Festklemmen in entsprechenden Rast- oder Schnappsitzen des Trägerkörpers 4 fixiert. Dabei werden die metallischen Kontaktstifte 19 in unterseitige hinterschnittene Nuten eines Brückenteils 21 der Trägerplatte 4 eingedrückt und dort eingerastet oder eingeschnappt, ebenso wie in endseitige Nuten oder Ausnehmungen 22 an der Unterseite der Trägerplatte 4, in die die Stifte 19 mit ihren inneren Enden 23 hineinragen. Im Bereich dieser inneren Enden 23 werden die Stifte 19 mit den Drähten 2 elektrisch verbunden, z.B. durch Löten oder Schweißen oder Schneidkontakte, gegebenenfalls auch durch bloßes Klemmen oder dgl. Kontaktierungstechniken.

Auch aus den Fig. 9 bis 11 sind im Übrigen die noppenförmigen Distanzelemente 6 an der Trägerplatte 4 ersichtlich, wobei diese Distanzelemente 6 zur Positionierung der Trägerplatte 4 samt Drähten 2 im Spritzgusswerkzeug (nicht dargestellt) dienen. Die Trägerplatte 4 sowie die Kunststoff-Umspritzung 5 bestehen aus einem entsprechend dem Einsatzzweck des Bauteils 1 gewählten geeigneten Kunststoff, z.B. einem Thermoplast. Bevorzugt wird der gleiche Kunststoff sowohl für die Herstellung der Trägerplatte 4 als auch für die Kunststoff-Umspritzung 5 gewählt. Als Beispiele für verwendbare Kunststoffe seien PE (Polyethylen), ABS (Acrylnitril-Butadien-Styrol), POM (Polyoxymethylen), PBT (Polybutylentherephthalat) mit/ohne Glasfaser, PP (Polypropylen) mit/ohne Glasfaser und PA (Polyamid) mit/ohne Glasfaser genannt.

Ganz allgemein können sich die Drähte 2 im Bauteil 1 je nach Notwendigkeit geradlinig, bogenförmig, um 90° abgewinkelt usw. erstrecken. Je nach Drahtverlauf eignen sich zur Fixierung der Drähte 2 an der Trägerplatte 4 beispielsweise rinnenförmige Aufnahmen 3 oder Halteclips 12. Letztere werden insbesondere dort mit Vorteil verwendet, wo durch stärkere Richtungsänderungen im Drahtverlauf vergleichsweise große Kräfte auftreten, vgl. Fig. 2 und 3, wo die Halteclips 12 in der Nähe von rechtwinkeligen Richtungsänderungen im Verlauf der Drähte 2 angebracht sind.

Bei der Herstellung eines Bauteils 1 mit elektrischer Leiterstruktur, wie vorstehend beschrieben, wird als erstes ein Trägerkörper 4 hergestellt, insbesondere aus Kunststoff gespritzt, wobei in einem Stück mit dem eigentlichen Körper 10 auch die die Aufnahmen 3 bildenden Teile (Wände 8, 9) bzw. Halteclips 12 mitgespritzt werden.

Im Trägerkörper 4 werden sodann mit Hilfe eines Drahtbestückungsroboters die Drähte 2 in die Aufnahmen 3 eingelegt, wobei die Drähte 2 wie beschrieben durch einen leichten Presssitz und/oder durch Verrastung und/oder durch Verprägen (bevorzugt während der Drahtbestückung) und/oder mit Hilfe der Halteclips 12 fixiert werden.

Der mit den Drähten 2 auf diese Weise bestückte Trägerkörper 4 wird sodann in einem Spritzgusswerkzeug mit der Fertig-Umspritzung 5 versehen, wobei dieser Kunststoff-Umspritzungsteil 5 gegebenenfalls auch mit entsprechenden Montagebereichen für externe, nachfolgend zu montierende Komponenten, wie den Motor 14 oder den Schalter 15 von Fig. 5, ausgebildet werden kann.

Sofern Steckerkontakte 18 vorhanden sind, werden noch vor dieser Umspritzung die Drähte 2 beispielsweise durch Schweißen oder Löten etc. mit diesen Steckerkontakten 18 verbunden.

Es ist im Übrigen auch möglich, auf dem Trägerkörper 4 vor dessen Umspritzen im Umspritzungs-Kunststoff einzubettende Bauelemente anzubringen, wie dies an sich aus EP 1 357 774 A1 bekannt ist. Insbesondere können auf diese Weise umspritzte Sensoren (z.B. kapazitive bzw. induktive Sensoren und/oder Wärme- bzw. Druck-Sensoren) vorgesehen werden.

Beim Herstellen der Kunststoff-Umspritzung 5 dienen wie erwähnt die noppenförmigen Distanzelemente 6 zur Positionierung des Trägerkörpers 4 im jeweiligen Spritzgusswerkzeug, d.h. der Trägerkörper 4 liegt mit diesen Distanzelementen 6 an den Formwänden des Spritzgusswerkzeuges an. Im Bereich der abgebogenen endseitigen Drahtstücke 2' der Drähte 2 sind entsprechende Ausnehmungen in der Form des Spritzgusswerkzeuges vorzusehen.

Anhand der Fig. 12 bis 17 wird nun noch eine Technik beschrieben, bei der die Drähte 2 in den Aufnahmen 3 des bevorzugt wiederum plattenförmigen Trägerkörpers 4 (und deshalb nachfolgend einfach als Trägerplatte 4 bezeichnet) durch Verprägen fixiert werden.

Im Einzelnen ist in Fig. 12 eine Trägerplatte 4 mit rinnenförmigen Draht-Aufnahmen 3 gezeigt, wobei diese Trägerplatte 4 mit den Aufnahmen 3 wiederum ein Fixierelement 4' für noch anzubringende elektrische Leiter, nämlich Drähte 2, bildet. Die Trägerplatte 4 ist gemäß der Darstellung in Fig. 12 wiederum mit Distanzelementen 6, insbesondere in Form von Noppen, wie gezeigt, versehen, um beim abschließenden Umspritzungsvorgang, zur Herstellung des Umspritzungsteils 5 (s. beispielsweise Fig. 1 oder Fig. 7), die Trägerplatte 4 in entsprechendem Abstand von den Formwänden des Spritzgusswerkzeuges zu halten.

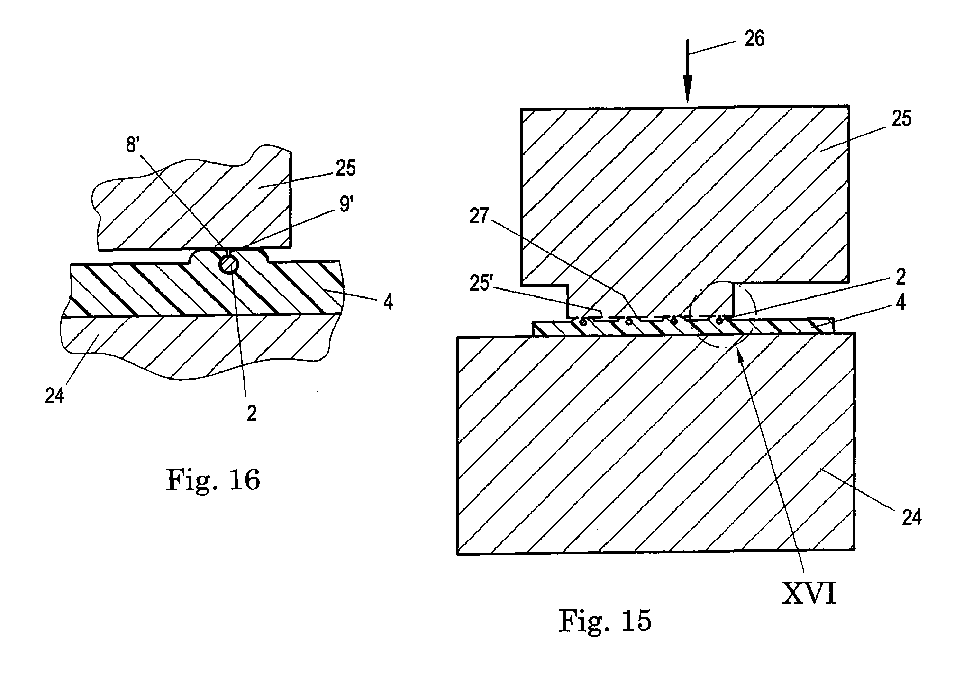

Gemäß Fig. 12 wird die Trägerplatte 4, die wiederum insbesondere aus Kunststoff durch Spritzgießen hergestellt sein kann, auf einer starren Unterlage 24 angebracht, die beim nachfolgenden Verprägen (wie anhand der Fig. 15 und 16 erläutert werden wird) als Gegenwerkzeug oder Gegenhalter dient.

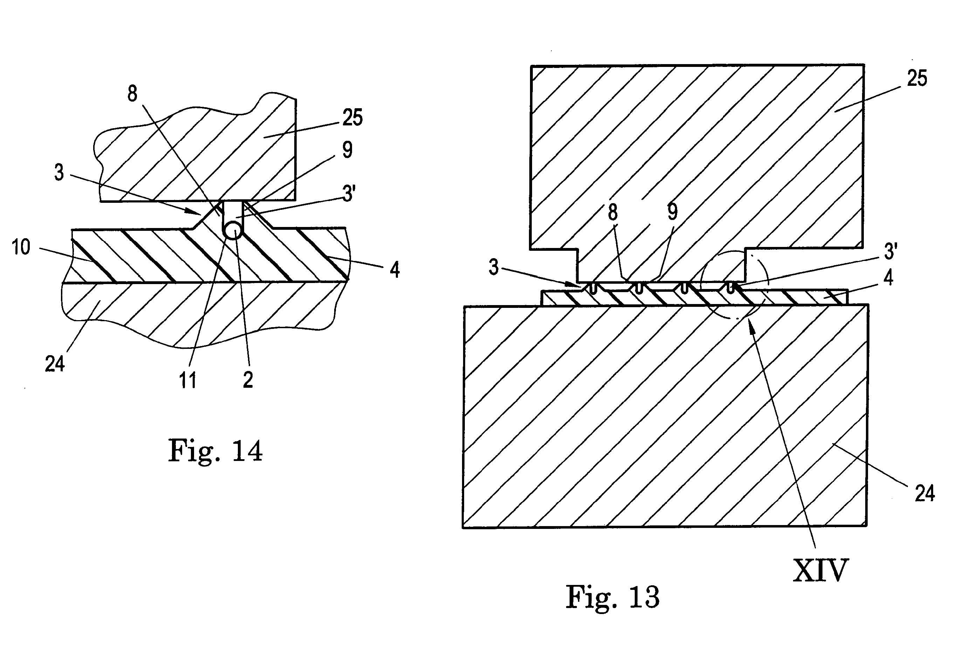

Im Anschluss an diese Anbringung der Trägerplatte 4 auf der Unterlage 24, gemäß Fig. 12, wird die Trägerplatte 4 durch ein Werkzeug in Form eines Prägestempels 25 klemmend fixiert, wie aus Fig. 13 ersichtlich ist. Der Prägestempel 25 verschließt dabei die offenen Oberseiten der Aufnahmen 3 für die einzulegenden Drähte (siehe Fig. 14). Die Aufnahmen 3 definieren mit den aufrechten Wänden 8, 9 sowie mit der Unterseite des Prägestempels 25 nunmehr tunnelförmige Kanäle 3', die im Querschnitt gesehen allseitig geschlossen sind.

In diese tunnelförmigen Kanäle 3' werden sodann die Drähte 2 der Länge nach, beispielsweise mit Hilfe eines an sich bekannten Vorschubautomaten, eingeschoben, so dass sich eine Anordnung wie aus Fig. 14 im Detail für eine der Aufnahmen 3 der Trägerplatte 4 ersichtlich ergibt. Aus Fig. 14 ist zu erkennen, dass der Kanal 3' an der Oberseite durch den Prägestempel 25 verschlossen ist; seitlich begrenzen die Wände 8, 9 den Kanal 3', dessen Boden durch eine Vertiefung 11 im Körper 10 der Trägerplatte 4 gebildet ist (d.h. dessen Boden im Vergleich zur Oberseite der Trägerplatte 4 tiefer liegt). Die Trägerplatte 4 liegt dabei weiterhin auf der Unterlage 24 auf, wobei es im einfachsten Fall auch genügen kann, die Trägerplatte 4 einfach auf die Unterlage 24 aufzulegen und durch Heranbewegen des Prägestempels 25 - vgl. Fig. 13 und 14 - klemmend gegen die Unterlage 24 zu drücken. Denkbar ist aber auch eine Montage mittels nicht gezeigter gesonderter Klemmhalter, Anschläge oder Sauglöcher.

Aus Fig. 15 und im Detail aus Fig. 16 ist zu erkennen, dass nach den vorstehend beschriebenen Einziehen oder Einschieben der Drähte 2 in die Kanäle 3' der Aufnahmen 3 der Prägestempel 25 zu einem Prägehub gemäß Pfeil 26 in Fig. 15 weiter abwärts bewegt wird, wobei die Wände 8, 9 plastisch verformt werden, so dass den eingelegten Draht 2 überdeckende Teile in der Art von Hinterschneidungen oder Überdeckungen 8', 9' gebildet werden, siehe Fig. 16. Hiefür kann der Prägestempel 25 einfach eine glatte Unterseite aufweisen, wie aus Fig. 13 und 14 hervorgeht, und wie in Fig. 15 mit einer strichlierten Linie 25' veranschaulicht ist. Es ist jedoch auch denkbar, im Bereich der Aufnahmen 3 der Trägerplatte 4, zu diesen ausgerichtet, taschenförmige Formvertiefungen anzubringen, wie aus Fig. 15 bei 27 hervorgeht.

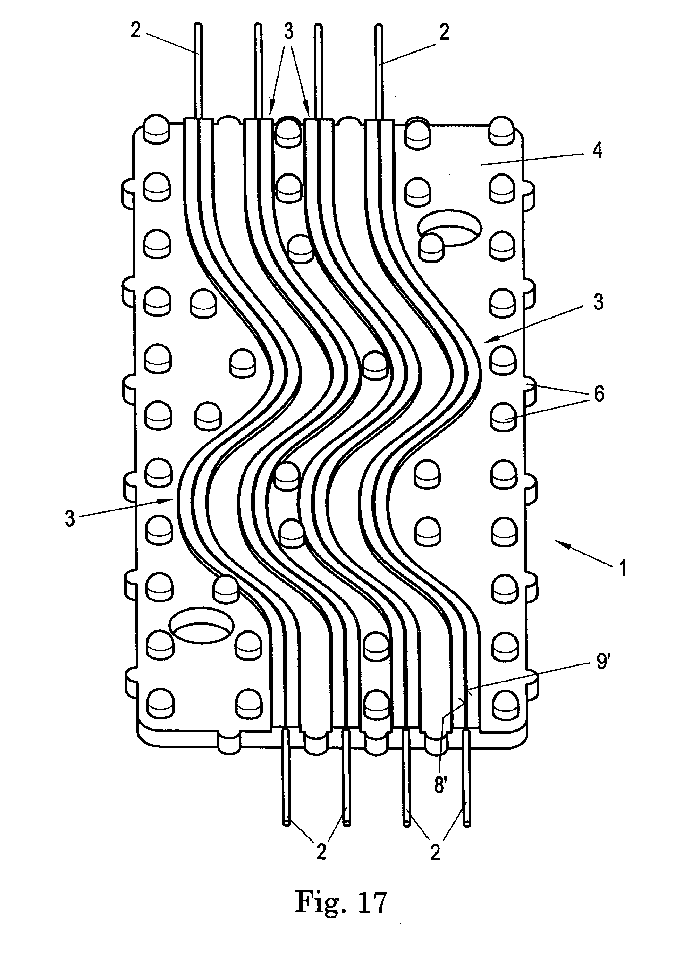

In Fig. 17 ist in einer schaubildlichen Darstellung der so erhaltene Leiterstruktur-Bauteil 1 mit der Trägerplatte 4 und den in deren Aufnahmen 3 formschlüssig durch Verprägen gehaltenen Drähten 2 gezeigt, wobei nachfolgend noch die vorstehend bereits erläuterte Umspritzung mit Kunststoff unter Verwendung der Noppen-Vorsprünge 6 als Distanzelemente im Spritzgusswerkzeug durchzuführen ist.

Selbstverständlich ist es auch im Fall des Ausführungsbeispiels gemäß den Fig. 12 bis 17 möglich, elektrische Komponenten, wie Schalter, Sensoren, Motoren usw. an der Trägerplatte 4 oder allgemein am Trägerkörper anzubringen, ebenso wie die anhand der Fig. 9 bis 11 speziell beschriebenen Steckerkontakte möglich sind.

## Patentansprüche

1. Fixierelement (4') für elektrische Leiter, für die Herstellung eines Leiterstruktur-Bauteils (1) durch Kunststoff-Umspritzung, **gekennzeichnet durch** einen vorzugsweise plattenförmigen, vorgefertigten Trägerkörper (4) mit Aufnahmen (3) für die Halterung von einzelnen Drähten (2) als elektrische Leiter.

2. Fixierelement nach Anspruch 1, **dadurch gekennzeichnet, dass** der Trägerkörper (4) aus Kunststoff gespritzt ist.

3. Fixierelement nach Anspruch 1 oder 2, **dadurch gekennzeichnet, dass** der Trägerkörper (4) z.B. noppenförmige Distanzelemente (6) aufweist.

4. Fixierelement nach einem der Ansprüche 1 bis 3, **dadurch gekennzeichnet, dass** die Aufnahmen (3) des Trägerkörpers (4) zumindest teilweise einen Presssitz für die Drähte (2) bilden.

5. Fixierelement nach einem der Ansprüche 1 bis 4, **dadurch gekennzeichnet, dass** am Trägerkörper (4) rinnenförmige Aufnahmen (3) für die Drähte vorgesehen sind.

6. Fixierelement nach Anspruch 5, **dadurch gekennzeichnet, dass** zumindest eine rinnenförmige Aufnahme (3) zumindest bereichsweise eine Hinterschneidung zum Festhalten des aufgenommenen Drahts (2) aufweist.

7. Fixierelement nach Anspruch 5 oder 6, **dadurch gekennzeichnet, dass** die rinnenförmigen Aufnahmen (3) zumindest teilweise durch hochstehende Rinnenwände (8, 9) begrenzt sind.

8. Fixierelement nach einem der Ansprüche 5 bis 7, **dadurch gekennzeichnet, dass** die rinnenförmigen Aufnahmen (3) zumindest teilweise durch Vertiefungen (11) im Trägerkörper (4) gebildet sind.

9. Fixierelement nach einem der Ansprüche 1 bis 8, **dadurch gekennzeichnet, dass** der Trägerkörper (4) zumindest einen elastisch verformbaren Halteclip (12) als Schnappsitz für den jeweiligen Draht (2) aufweist.

10. Fixierelement nach Anspruch 9, **dadurch gekennzeichnet, dass** der Halteclip (12) im Bereich eines gekrümmten Verlaufs des Drahtes (2) am Trägerkörper (4) vorgesehen ist.

11. Fixierelement nach einem der Ansprüche 1 bis 10, **dadurch gekennzeichnet, dass** am Trägerkörper (4) randseitig Steckerkontakte (18) fixiert, z.B. festgeklemmt, sind.

12. Fixierelement nach einem der Ansprüche 1 bis 11, **dadurch gekennzeichnet, dass** Drähte (2) in den Aufnahmen (3) gehalten sind.

13. Fixierelement nach Anspruch 11 und 12, **dadurch gekennzeichnet, dass** die Drähte (2) mit den Steckerkontakten (18), z.B. durch Löten, Schweißen, Schneidkontakte, Klemmen oder dgl., elektrisch verbunden sind.

14. Fixierelement nach Anspruch 12 oder 13, **dadurch gekennzeichnet, dass** zumindest einige Drähte (2) vom Trägerkörper (4) abgebogen sind und zwecks Verbindung mit einer Komponente, wie z.B. einem Schalter (15) und/oder einem Elektromotor (14), hochragen.

15. Elektrischer Leiterstruktur-Bauteil (1) mit einem Fixierelement (4') nach einem der Ansprüche 1 bis 14 und elektrischen Leitern innerhalb einer Kunststoff-Umspritzung (5), **dadurch gekennzeichnet, dass** Drähte (2) in Aufnahmen (3) des Trägerkörpers (4) des Fixierelements (4') gehalten sind, und dass die Trägerplatte (4) samt den Drähten (2) in der Kunststoff-Umspritzung (5) eingebettet ist.

16. Leiterstruktur-Bauteil nach Anspruch 15, **dadurch gekennzeichnet, dass** die Drähte (2) zumindest teilweise in einem Presssitz in den Aufnahmen (3) gehalten sind.

17. Leiterstruktur-Bauteil nach Anspruch 15 oder 16, **dadurch gekennzeichnet, dass** die Drähte (2) zumindest teilweise in einem Schnappsitz in einer rinnenförmigen Aufnahme (3) mit einer Hinterschneidung gehalten sind.

18. Leiterstruktur-Bauteil nach einem der Ansprüche 15 bis 17, **dadurch gekennzeichnet, dass** die Drähte (2) zumindest teilweise formschlüssig in einer rinnenförmigen Aufnahme (3) mit einer durch Verprägen hergestellten Hinterschneidung bzw. Überdeckung (8', 9') gehalten sind.

19. Leiterstruktur-Bauteil nach einem der Ansprüche 15 bis 18, **dadurch gekennzeichnet, dass** der Trägerkörper (4) zumindest einen vor der Kunststoff-Umspritzung (5) elastisch verformbaren Halteclip (12) als Schnapphalterung für den aufgenommenen Draht (2) aufweist.

20. Leiterstruktur-Bauteil nach Anspruch 19, **dadurch gekennzeichnet, dass** der Halteclip (12) im Bereich eines gekrümmten Verlaufs des Drahtes (2) am Trägerkörper (4) vorgesehen ist.

21. Leiterstruktur-Bauteil nach einem der Ansprüche 15 bis 20, **dadurch gekennzeichnet, dass** am Trägerkörper (4) Steckerkontakte (18) fixiert, z.B. festgeklemmt, sind, mit denen die Drähte (2), z.B. durch Löten, Schweißen, Schneidkontakte, Klemmen oder dgl., elektrisch verbunden sind, und die aus der Kunststoff-Umspritzung (5) vorstehen.

22. Leiterstruktur-Bauteil nach Anspruch 21, **dadurch gekennzeichnet, dass** die Kunststoff-Umspritzung (5) einen die Steckerkontakte (18) umgebenden Gehäuseteil (20) bildet.

23. Leiterstruktur-Bauteil nach einem der Ansprüche 15 bis 22, **dadurch gekennzeichnet, dass** zumindest einige Drähte (2) vom Trägerkörper (4) abgebogen sind und durch die Kunststoff-Umspritzung (5) zwecks Verbindung mit einer äußeren Komponente, wie z.B. mit einem Schalter (15) und/oder einem Elektromotor (14), nach außen ragen.

24. Leiterstruktur-Bauteil nach einem der Ansprüche 15 bis 23, **dadurch gekennzeichnet, dass** der Trägerkörper (4) z.B. noppenförmige Distanzelemente (6) aufweist, die innerhalb der Kunststoff-Umspritzung (5) liegen und sich zumindest teilweise bis zu deren Außenseite erstrecken.

25. Verfahren zum Herstellen eines elektrischen Leiterstruktur-Bauteils, wobei elektrische Leiter mit Kunststoff umspritzt werden, **dadurch gekennzeichnet, dass** ein vorzugsweise plattenförmiger Trägerkörper (4) mit Aufnahmen (3) für Drähte (2) hergestellt wird, dass als elektrische Leiter vorgesehene Drähte (2) in die Aufnahmen (3) des Trägerkörpers (4) eingelegt und darin in ihrer Position fixiert werden, und dass der Trägerkörper (4) samt den Drähten (2) mit Kunststoff umspritzt wird.

26. Verfahren nach Anspruch 25, **dadurch gekennzeichnet, dass** der Trägerkörper (4) aus Kunststoff gespritzt wird.

27. Verfahren nach Anspruch 25 oder 26, **dadurch gekennzeichnet, dass** die Drähte (2) zumindest teilweise in einem Presssitz in den Aufnahmen (3) fixiert werden.

28. Verfahren nach einem der Ansprüche 25 bis 27, **dadurch gekennzeichnet, dass** die Drähte (2) zumindest teilweise mittels Schnapphalterung am Trägerkörper (4) fixiert werden.

29. Verfahren nach einem der Ansprüche 25 bis 28, **dadurch gekennzeichnet, dass** die Drähte (2) zumindest teilweise mittels Verprägen am Trägerkörper (4) fixiert werden.

30. Verfahren nach Anspruch 29, **dadurch gekennzeichnet, dass** die Drähte (2) nach Heranführen eines Prägestempels (25) an die Oberseite der mit hochstehenden Wänden (8, 9) gebildeten Aufnahmen (3), um diese zu verschließen, in die beim Verschließen gebildeten tunnelartigen Kanäle (3') eingeschoben werden.

31. Verfahren nach Anspruch 30, **dadurch gekennzeichnet, dass** die hochstehenden Wände (8, 9) der Aufnahmen (3) nach dem Einschieben der Drähte durch einen Prägehub des Prägestempels (25) unter Bildung einer Hinterschneidung oder Überdeckung (8', 9') verformt werden.

32. Verfahren nach einem der Ansprüche 25 bis 31, **dadurch gekennzeichnet, dass** der Trägerkörper (4) automatisch mit den Drähten (2) bestückt wird.

33. Verfahren nach einem der Ansprüche 25 bis 32, **dadurch gekennzeichnet, dass** zumindest in einem Randbereich des Trägerkörpers (4) vor dem Umspritzen Steckerkontakte (18) fixiert, z.B. festgeklemmt, werden, mit denen die Drähte (2), z.B. durch Löten, Schweißen, Klemmen, Schneidkontakte oder dgl., elektrisch verbunden werden.

34. Verfahren nach einem der Ansprüche 25 bis 33, **dadurch gekennzeichnet, dass** zumindest einige Drähte (2) vom Trägerkörper (4) hochgebogen werden, wobei jeweils der hochstehende Drahtteil (2') so lang bemessen wird, dass er nach dem Umspritzen mit Kunststoff aus der Umspritzung (5) für eine Kontaktierung vorsteht.

35. Verfahren nach einem der Ansprüche 25 bis 34, **dadurch gekennzeichnet, dass** der Trägerkörper (4) mit z.B. noppenförmigen Distanzelementen (6) hergestellt wird, die den Trägerkörper (4) beim Umspritzen im Werkzeug abstützen.
